(19) Europäisches Patentamt
European Patent Office
Office européen des brevets

(11) **EP 3 428 696 B1**

(12) **EUROPÄISCHE PATENTSCHRIFT**

(45) Veröffentlichungstag und Bekanntmachung des Hinweises auf die Patenterteilung:
**20.07.2022 Patentblatt 2022/29**

(21) Anmeldenummer: **17196142.8**

(22) Anmeldetag: **12.10.2017**

(51) Internationale Patentklassifikation (IPC):
**G02B 5/08** (2006.01)      **H01L 33/62** (2010.01)
**H01L 33/60** (2010.01)

(52) Gemeinsame Patentklassifikation (CPC):
(C-Sets verfügbar)
**G02B 5/0858; C23C 4/06; H01L 33/60;**
**H01L 33/62; H05K 1/111;** H01L 24/32; H01L 24/48;
H01L 24/73; H01L 24/85; H01L 2224/32245;
H01L 2224/45144; H01L 2224/48091;
H01L 2224/48247; H01L 2224/48257;
H01L 2224/73265;        (Forts.)

(54) **REFLEKTIERENDES VERBUNDMATERIAL, INSBESONDERE FÜR OBERFLÄCHENMONTIERTE BAUELEMENTE (SMD), UND LICHTEMITTIERENDE VORRICHTUNG MIT EINEM DERARTIGEN VERBUNDMATERIAL**

REFLECTIVE COMPOSITE MATERIAL, IN PARTICULAR FOR SURFACE-MOUNTED COMPONENTS (SMD), AND LIGHT-EMITTING DEVICE COMPRISING SUCH A COMPOSITE MATERIAL

MATÉRIAU COMPOSITE RÉFLÉCHISSANT, EN PARTICULIER POUR COMPOSANTS MONTÉS EN SURFACE (SMD) ET DISPOSITIF ÉMETTANT DE LA LUMIÈRE POURVU D'UN TEL MATÉRIAU COMPOSITE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2017 DE 102017115798**

(43) Veröffentlichungstag der Anmeldung:
**16.01.2019 Patentblatt 2019/03**

(73) Patentinhaber: **ALANOD GmbH & Co. KG**
**58256 Ennepetal (DE)**

(72) Erfinder: **ZIEGLER, Stefan**
**45549 Sprockhövel (DE)**

(74) Vertreter: **Dr. Solf & Zapf**
**Patent- und Rechtsanwalts PartG mbB**
**Schlossbleiche 20**
**42103 Wuppertal (DE)**

(56) Entgegenhaltungen:
**EP-A1- 2 416 389**      **EP-A2- 1 876 653**
**DE-A1-102015 114 095**

(52) Gemeinsame Patentklassifikation (CPC): (Forts.)
H01L 2224/85205; H01L 2924/12035;
H01L 2924/12041; H01L 2933/0016; H05K 1/0209;
H05K 3/202; H05K 3/328; H05K 2201/0338;
H05K 2201/10106; H05K 2201/2054; Y02P 70/50

C-Sets
H01L 2224/48091, H01L 2924/00014;
H01L 2224/73265, H01L 2224/32245,
H01L 2224/48247, H01L 2924/00012;
H01L 2224/73265, H01L 2224/32245,
H01L 2224/48257, H01L 2924/00

## Beschreibung

Die vorliegende Erfindung betrifft ein reflektierendes Verbundmaterial, mit einem aus Aluminium bestehenden Träger, mit einer auf dem Träger befindlichen Zwischenschicht aus Aluminiumoxid und mit einem über der Zwischenschicht aufgebrachten, reflexionsverstärkenden optisch wirksamen Mehrschichtsystem. Unter einem "aus Aluminium bestehenden Träger" werden dabei auch Aluminiumlegierungen subsumiert.

Des Weiteren betrifft die vorliegende Erfindung eine lichtemittierende Vorrichtung mit einem derartigen reflektierenden Verbundmaterial.

Ein Verbundmaterial der eingangs genannten Art ist beispielsweise aus der WO 00/29784 A1 bekannt. Den Schwerpunkt dieser Anmeldung bildet dabei eine auf der Oberfläche des optisch wirksamen Systems befindliche Schutzschicht. Das reflexionsverstärkende optisch wirksame Mehrschichtsystem, welches auch als funktionelle Beschichtung bezeichnet wird, enthält dabei eine reflektierende Schicht, wie z. B. eine Schicht aus Aluminium, Silber, Kupfer, Gold, Chrom, Nickel oder deren Legierungen. Zwischen dem Träger und der funktionellen Beschichtung kann dabei als Zwischenschicht wenigstens eine Vorbehandlungsschicht angeordnet sein, welche im Falle eines Trägers aus Aluminium beispielsweise eine durch anodische Oxidation des Trägers erzeugte Schicht sein kann. Es wird dazu ausgeführt, dass es allgemein bekannt sei, Bänder aus Glänzwerkstoffen, z. B. aus Reinstaluminium auf Basis von Aluminium mit einem Reinheitsgrad von 99,8 % und größer, wie z. B. 99,9 %, oder aus AlMg-Legierungen, herzustellen, desgleichen auch Walzoberflächen mit diffuser oder gerichteter Lichtreflexion zu erzeugen. Es sei auch bekannt, zur Erhöhung der gerichteten Reflexion die Oberflächen von solchen Bändern chemisch oder elektrolytisch zu glänzen und anschließend durch anodische Oxidation eine Aluminiumoxid-Schutzschicht von z. B. 1,5 $\mu$m Schichtdicke zu erzeugen. Eine sich natürlicherweise auf Aluminium bildende Oxidschicht erreicht stattdessen nur eine Dicke von etwa 0,005 $\mu$m.

In der DE 103 40 005 A1 wird eine lichtemittierende Vorrichtung zur Aussendung von weißem Licht beschrieben, die ein nicht näher spezifiziertes, elektrisch isolierendes Substrat mit zwei Anschlusselektroden umfasst, welche an der oberen Oberfläche und an der Unterseite des Substrats vorgesehen sind. Die bekannte Vorrichtung umfasst dabei eine auf dem Substrat platzierte, als Chip ausgeführte lichtemittierende Diode (LED). Die Kathode dieser lichtemittierenden Diode ist mit einer der Elektroden durch ein Klebemittel verbunden, und die Anode ist mit der anderen Elektrode durch einen Bond-Draht verbunden. Die LED und die obere Oberfläche des Substrats sind von einem transparenten Harz bedeckt.

Charakteristisch für die in der DE 103 40 005 A1 praktizierte Montageweise ist dabei die so genannte Oberflächenmontage des LED-Chips, der auch als "Die" (englisch für Würfel oder Plättchen) bezeichnet wird. Diese Montagetechnik wird in englischer Sprache als Surface-mounting technology "SMT" bezeichnet. Die außerdem in diesem Zusammenhang ebenfalls verwendete Abkürzung "SMD" (englisch: Surface-mounted device) beschreibt dabei das oberflächenmontierte Bauelement, welches - im Gegensatz zu Bauelementen der herkömmlichen Durchsteckmontage (Through Hole Technology, "THT") mit "bedrahteten Bauelementen" - keine Drahtanschlüsse aufweist, sondern mittels insbesondere lötfähiger Anschlussflächen (hier in der DE 103 40 005 A1 allerdings mit einem Klebemittel) als so genannte Flachbaugruppe direkt auf einer Leiterplatte montiert wird.

Für derartige Anschlusselektroden-Strukturen ist auch die englische Bezeichnung "lead frame" üblich, wozu exemplarisch auf die US 6,407,411 B1 verwiesen wird. In diesem Zusammenhang ist zu erwähnen, dass im Bereich der SMD-LEDs als Material der "lead frames" heute üblicherweise versilbertes Kupfer verwendet wird, welches jedoch nachteiligerweise eine geringe Beständigkeit gegenüber Schwefelwasserstoff hat und eine Reflektivität in der Größenordnung von nur ca. 93 % ausweist.

Bei der in der DE 103 40 005 A1 beschriebenen Montageweise handelt es sich außerdem um die Anwendung der sogenannten "COB-Technologie" (englisch: Chip-on-Board-Technology), die auch als Nacktchipmontage bezeichnet wird. Dies ist eine Technologie zur Direktmontage von ungehausten Halbleiter-Chips auf Platinen zur Herstellung von elektronischen Baugruppen. Heute verwendet man den Begriff "COB" für alle Baugruppen, die den nackten Halbleiter beinhalten, während man darunter ursprünglich ausschließlich nach der sogenannten Chip-and-Wire-Technik gefertigte Baugruppen verstand. Anmeldungsgemäß wird das neuere, weitere Verständnis zugrunde gelegt, wobei dieses die Chip-and-Wire-Technik, wie sie die DE 103 40 005 A1 für den LED-Chip vorsieht, inhaltlich umfasst.

Ein bedeutender Vorteil von LED-Vorrichtungen ist ihre hohe Lichtausbeute $\eta_v$ (englisch: luminous efficacy). Unter der Lichtausbeute wird der Quotient aus dem von einer Lichtquelle abgegebenen Lichtstrom $\Phi_v$ und der von ihr aufgenommenen Leistung P verstanden. Die SI-Einheit der Lichtausbeute ist Lumen pro Watt (lm/W). Je größer der Wert der Lichtausbeute ist, desto größer ist auch der für das Auge nutzbare Lichtstrom bei gegebener Leistungsaufnahme P der Lampe. Die Lichtausbeute $\eta_v$ einer Lampe setzt sich dabei aus zwei Faktoren zusammen: der Strahlungsausbeute $\eta_e$ der Lampe und dem photometrischen Strahlungsäquivalent K der abgegebenen Strahlung:

$$\eta_v = \eta_e * K.$$

Während die Lichtausbeute einer herkömmlichen Glühlampe bei 10 bis 30 lm/Watt liegt, beträgt sie bei LED-Lampen vorteilhafterweise mehr als das Doppelte, nämlich 60 bis 100 lm/Watt.

In der EP 2 138 761 A1 wird ausgeführt, dass aus Aluminium bestehende, insbesondere beschichtete, Reflektoren zur Erzielung vergleichsweise hoher Beleuchtungsstärken bzw. Lichtausbeuten $\eta_v$ - d. h. hoher Wirkungsgrade - verwendet werden können. Der Gesamtreflexionsgrad eines als Reflektor eingesetzten hoch reflektierenden Trägers führt auch zu einer hohen Lichtausbeute. Dem Begriff "hoch reflektierend" wird dabei anmeldungsgemäß das gleiche Verständnis zugrunde gelegt, wie dieses in der genannten EP 2 138 761 A1 erläutert ist. Das heißt, im Folgenden werden unter "hoch reflektierend" Materialien verstanden, welche nach DIN 5036, Teil 3 (Ausgabe 11/79) einen Gesamtreflexionsgrad von mindestens 85 %, vorzugsweise von mindestens 90 %, besonders bevorzugt von mindestens 95 %, aufweisen.

Als Trägermaterial für Reflektoren mit hohem Gesamtreflexionsgrad wird - wie bereits erwähnt - weithin gewalztes Aluminium mit einer Mindestreinheit von 99,8 % verwendet, auf dem als Basis für darüber liegende PVD-Schichten und als chemische Schutzschicht die Zwischenschicht aufgebracht wird. Diese schützende Zwischenschicht entsteht bevorzugt in einem nasschemischen Eloxierprozess, wobei dadurch erreicht wird, dass die Oberfläche eine genügend geringe Rauigkeit und eine ausreichende Härte aufweist sowie defektfrei ausgebildet ist, wobei eventuell noch vorhandene Poren der Aluminiumoxidschicht in der letzten Phase der Prozesskette weitestgehend durch eine Heißverdichtung verschlossen werden können. Durch Änderungen der Reinheit und/oder der Rauheit kann dabei Einfluss auf die Höhe der Gesamtreflexion genommen werden, während durch gezielte Veränderungen der Walzstruktur des Aluminiumträgers ein Grad von diffuser Reflexion beeinflusst werden kann. Wenn das insbesondere bandförmige Aluminium-Trägermaterial zur Erzeugung der Zwischenschicht in das Bad zur anodischen Oxidation bzw. zum nasschemischen Eloxieren gebracht wird, entsteht sowohl auf seiner Oberseite die Aluminiumoxid-Zwischenschicht, als auch auf seiner Unterseite eine weitere Aluminiumoxid-Schicht mit im Wesentlichen gleichem Aufbau.

Das dann nachfolgend über der Zwischenschicht aufgebrachte optisch wirksame Mehrschichtsystem kann beispielsweise aus mindestens drei Schichten bestehen, wobei die oberen Schichten dielektrische und/oder oxidische Schichten sind, und die unterste Schicht eine metallische Schicht ist, welche eine Reflexionsschicht bildet. Hierbei kann es sich bei der metallischen Schicht z. B. um eine hochreflektierende Reinstsilber-Schicht handeln, die auf der Eloxalschicht abgeschieden ist. Sie ist optisch dicht und weist im sichtbaren Bereich des Lichtes eine extrem hohe Gesamtreflexion auf. Ein solches Verbundmaterial der eingangs genannten Art hat als oberflächenveredeltes Aluminiumband unter dem Namen MIRO®-Silver weite Verbreitung für die Beleuchtungstechnik, Tageslichtsysteme und dekorative Anwendungen gefunden.

Weitere bekannte Verbundmaterialien der eingangs genannten Art mit Silber-Reflexionsschichten sind in der DE 10 2015 114 095 A1 sowie in der WO 2017/032809 A1 beschrieben. Wegen ihres vorteilhaft hohen Gesamtreflexionsgrades und ihrer dabei exzellenten Langzeitstabilität erscheint es wünschenswert, diese und andere derartige Verbundmaterialien im Rahmen der vorstehend beschriebenen Surface-mounting- und Chip-on-Board-Technologien als Trägermaterial, z. B. als Lead-Frame-Strukturen, für Surface-mounted devices (SMD), insbesondere für LED-Halbleiter-Chips, einzusetzen. So wird in der DE 10 2015 114 095 A1 sowie in der WO 2017/032809 A1 die Platzierung von LED-Leuchtquellen, z. B. in Form eines Chips, auf der Oberfläche des dort beschriebenen Verbundmaterials als bevorzugter Anwendungsfall angesprochen. Jedoch hat sich gezeigt, dass die bekannten Verbundmaterialien im Rahmen der genannten Technologien, insbesondere auch bei Verwendung der Chip-and-Wire-Technik, zu Problemen bei der elektrischen Kontaktierung der SMD führen können.

Der vorliegenden Erfindung liegt die Aufgabe zugrunde, ein Verbundmaterial der eingangs beschriebenen Art mit hoher Reflektivität und vorzugsweise auch hoher Langzeitstabilität, d. h. mit einer langzeitlich geringen Einbuße des Licht-Gesamtreflexionsgrades, zu schaffen, das bei Anwendung einer Oberflächenmontage, insbesondere bei Anwendung der Chip-and-Wire-Technik, eine verbesserte elektrische Konnektierungsfähigkeit aufweist.

Diese Aufgabe wird erfindungsgemäß durch ein Verbundmaterial nach Anspruch 1 gelöst.

Vorteilhafterweise wird so erfindungsgemäß im Rahmen des so genannten Wire-bondings einerseits ein Verschweißen eines Drahtes, insbesondere das Ultraschallschweißen eines Golddrahtes, auf der Vorder- bzw. Oberseite des erfindungsgemäßen Verbundmaterials zur Herstellung einer Verbindung zwischen der Oberfläche des Verbundmaterials und einem auf dem Verbundmaterial durch Oberflächenmontage aufgebrachten elektronischen Bauteil problemlos ermöglicht, und andererseits zeigt sich, dass der elektrische Übergangs-Widerstand auf der Rück- bzw. Unterseite des erfindungsgemäßen Verbundmaterials überraschenderweise vernachlässigbar klein ist. So kann diese Seite problemlos auf eine gedruckte Leiterplatte (englisch: Printed Circuit Board - PCB) gelötet oder mittels eines ähnlichen stoffschlüssig wirkenden Verbindungsverfahrens, z. B. unter Einsatz eines elektrisch leitenden Lackes oder auch Klebstoffs, aufgebracht werden. Die Auswahl des Materials und die Dicke der oberflächlich aufgebrachten Schicht eines Metalls oder einer Metalllegierung können vorteilhafterweise unter den verschiedensten Aspekten, wie beispielsweise Wert des spezifischen elektrischen Widerstandes, Temperaturbeständigkeit, insbesondere bei einem Löten, Lotkompatibilität, Verfügbarkeit, Preis usw. optimal aufeinander abgestimmt werden.

Bevorzugt kann es sich unter diesen Gesichtspunkten bei der oberflächlich aufgebrachten Schicht eines Metalls oder einer Metalllegierung um eine Kupferschicht mit einer Dicke im Bereich von 0,1 $\mu$m bis 5,0 $\mu$m oder um eine Silberschicht mit einer Dicke im Bereich von 10 nm bis 500 nm handeln.

Eine erfindungsgemäße lichtemittierende Vorrichtung umfasst das erfindungsgemäße reflektierende Verbundmaterial, welches eine Rahmen-Tragstruktur ("lead frame") für ein elektronisches Bauelement, wie eine als Nackt-Chip (Die) ausgebildete lichtemittierende Diode, bildet, wobei das elektronische Bauelement oberseitig auf der Rahmen-Tragstruktur aufliegt und befestigt ist sowie mittels eines separaten Drahtes elektrisch mit der Rahmen-Tragstruktur kontaktiert ist, und wobei der Verbund aus dem elektronischen Bauelement (als SMD) und der Rahmen-Tragstruktur ("lead frame") unterseitig mit einer gedruckten Leiterplatte (PCB) elektrisch leitend stoffschlüssig verbunden ist.

Der Ersatz der üblichen, aus silberplattiertem Kupfer bestehenden Rahmenstruktur durch das erfindungsgemäße Verbundmaterial bewirkt dabei, insbesondere wenn sich kein Silber in der oberflächlich aufgebrachten Schicht befindet, eine erhöhte Korrosionsbeständigkeit, insbesondere gegenüber Schwefelwasserstoff, wobei sich in jedem Fall gleichzeitig die Lichtausbeute erhöht, indem sie insbesondere Werte weit über 100 lm/W annehmen kann.

Weitere vorteilhafte Ausführungen der Erfindung sind in den Unteransprüchen und in der nachfolgenden detaillierten Beschreibung enthalten.

Anhand eines durch die beiliegende Zeichnung veranschaulichten Ausführungsbeispiels wird die Erfindung näher erläutert. Dabei zeigen:

Fig. 1    eine vergrößerte prinzipielle Schnittdarstellung durch eine Ausführungsform eines erfindungsgemäßen Verbundmaterials, wobei die darin enthaltenen Schichtdicken rein schematisch und nicht maßstabsgerecht dargestellt sind,

Fig. 2    eine Aufsicht auf einen Teilbereich einer Ausführungsform einer erfindungsgemäßen lichtemittierenden Vorrichtung,

Fig. 3    eine Aufsicht auf eine Ausführungsform einer aus einem erfindungsgemäßen Verbundmaterial gebildeten Rahmen-Tragstruktur für eine erfindungsgemäße lichtemittierende Vorrichtung und

Fig. 4    einen Querschnitt durch eine Ausführungsform einer erfindungsgemäßen lichtemittierenden Vorrichtung.

Zu der anschließenden Beschreibung wird ausdrücklich betont, dass die Erfindung nicht auf das Ausführungsbeispiel und dabei auch nicht auf alle oder mehrere Merkmale von beschriebenen Merkmalskombinationen beschränkt ist. Vielmehr kann jedes einzelne Teilmerkmal des Ausführungsbeispiels auch losgelöst von allen anderen im Zusammenhang damit beschriebenen Teilmerkmalen für sich und auch in Kombination mit beliebigen geeigneten weiteren Merkmalen eine erfinderische Bedeutung haben.

In den verschiedenen Figuren der Zeichnung sind dieselben Teile auch stets mit denselben Bezugszeichen versehen, so dass sie in der Regel auch jeweils nur einmal beschrieben werden.

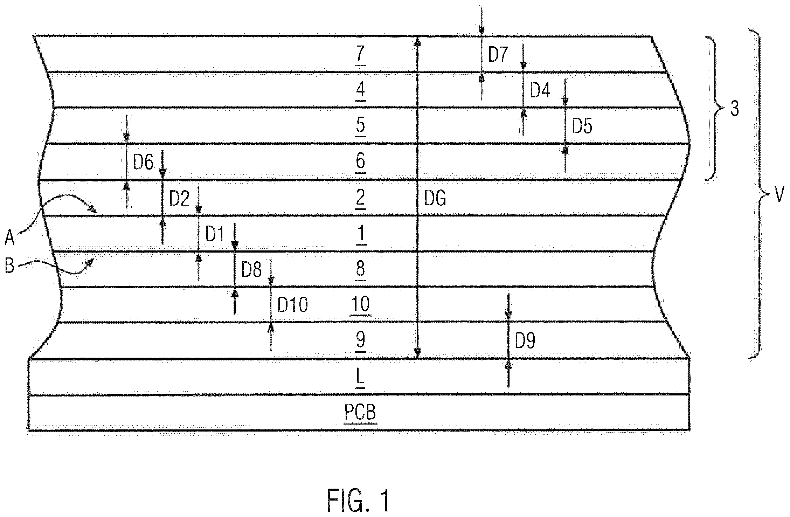

Wie zunächst aus Fig. 1 hervorgeht, weist ein erfindungsgemäßes reflektierendes Verbundmaterial V mit einem aus Aluminium bestehenden Träger 1, eine auf einer Seite A auf dem Träger 1 befindliche Zwischenschicht 2 aus Aluminiumoxid und ein auf der Zwischenschicht 2 aufgebrachtes, reflexionsverstärkendes optisch wirksames Mehrschichtsystem 3 auf. Der Träger 1 weist eine Ausbildung als Coil mit einer Breite bis zu 1600 mm, vorzugsweise von 1250 mm, und mit einer Dicke $D_1$ von etwa 0,1 bis 1,5 mm, vorzugsweise von etwa 0,2 bis 0,8 mm, auf.

Da alle auf dem Träger befindlichen dünnen Schichten, insbesondere die Zwischenschicht 2 und die des optisch wirksamen Mehrschichtsystems 3, demgegenüber vernachlässigbar klein sind, ist die Trägerdicke $D_1$ von ihrer Größe her auch gleichzeitig repräsentativ für eine Gesamtdicke DG des erfindungsgemäßen Verbundmaterials V.

Das Aluminium des Trägers 1 kann insbesondere eine höhere Reinheit als 99,0 % aufweisen, wodurch seine Wärmeleitfähigkeit gefördert wird. Dadurch kann die Entstehung von Wärmepeaks verhindert werden. Beispielsweise kann es sich bei dem Träger 1 aber auch um ein bandförmiges Aluminiumblech Al 98.3, also mit einer Reinheit von 98,3 Prozent handeln. Es ist auch möglich, als Träger 1 Aluminiumlegierungen, wie beispielsweise eine AlMg-Legierung, einzusetzen, insofern daraus durch anodische Oxidation die Zwischenschicht 2 gebildet werden kann.

Das optisch wirksame Mehrschichtsystem 3 kann exemplarisch - wie dargestellt - aus mindestens drei Schichten bestehen, wobei davon zwei obere Schichten 4, 5 dielektrische und/oder oxidische Schichten sind, und die darunter liegende unterste Schicht 6 eine metallische, z. B. aus Aluminium oder Silber bestehende, Schicht ist, welche eine Reflexionsschicht 6 bildet.

Zusätzlich ist im dargestellten Fall eine optional vorhandene, schützende nichtmetallische, aus einem absorptionsarmen Material, wie beispielsweise Siliciumdioxid, bestehende Deckschicht 7 dargestellt. Ein solcher Schichtaufbau ist aus dem deutschen Gebrauchsmuster DE 2 98 12 559 U1 bekannt, auf das in diesem Zusammenhang in vollem Umfang verwiesen wird. So können die dielektrischen und/oder oxidischen Schichten 4, 5 des optischen Mehrschichtsystems 3 beispielsweise jeweils eine Dicke $D_4$, $D_5$ im Bereich von 30 nm bis 200 nm, aufweisen, wobei diese Dicke

$D_4$, $D_5$ jeweils bevorzugt ein Viertel der Mittenwellenlänge des Spektralbereiches der zu reflektierenden elektromagnetischen Strahlung beträgt, damit die Schichten 4, 5 als reflexionserhöhende Interferenzschichten wirken können. Eine Dicke $D_7$ der Schutzschicht 7 kann im Bereich von 0,5 nm bis 20 nm, vorzugsweise im Bereich von 0,5 nm bis 10 nm, liegen. Es kann auch vorgesehen sein, dass auf das optische Mehrschichtsystem 3 eine siliciumnitridische Schutzschicht als Deckschicht 7 aufgebracht ist.

Das optische Mehrschichtsystem 3 - einschließlich der Deckschicht 7 und vorteilhafterweise auch der noch nachstehend beschriebenen, insbesondere als Kupferschicht ausgebildeten, Schicht 9 eines Metalls oder einer Metalllegierung - kann in technologisch vorteilhafter Weise unter Anwendung eines kontinuierlichen Vakuum-Bandbeschichtungsprozesses appliziert werden. Insbesondere kann es sich dabei bei den Schichten 4, 5, 6, 7, 9 um Sputterschichten, insbesondere durch Reaktivsputtern erzeugte Schichten, CVD- oder PECVD-Schichten oder um durch Verdampfen, insbesondere durch Elektronenbombardement oder aus thermischen Quellen, erzeugte Schichten handeln.

Die Reflexionsschicht 6 kann optional über eine nicht dargestellte, beispielsweise aus Aluminium- Titan- und/oder Chromoxid bestehende, Haftvermittlerschicht an die Zwischenschicht 2 angebunden sein. Des Weiteren kann die Reflexionsschicht 6 optional ober- und unterseitig zwischen nicht dargestellten Barriereschichten, z. B. aus Nickel, Nickellegierungen oder Palladium, eingebettet sein, um die Temperaturstabilität zu erhöhen.

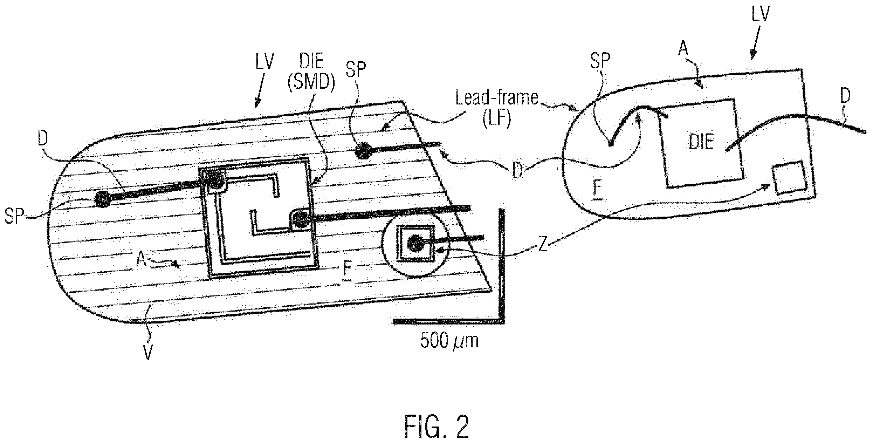

Die obere dielektrische und/oder oxidische Schicht 4 des optischen Mehrschichtsystems 3 ist eine höher brechende Schicht als die untere dielektrische und/oder oxidische Schicht 5 des optischen Mehrschichtsystems 3, wobei die obere Schicht 4 vorzugsweise aus $TiO_2$, $Ta_2O_5$, $Nb_2O_5$, $MoO_3$ und/oder $ZrO_2$, und die untere Schicht 5 vorzugsweise aus $Al_2O_3$ und/oder $SiO_2$ bestehen kann. Erfindungsgemäß ist vorgesehen, dass die aus Aluminiumoxid bestehende, insbesondere aus anodisch oxidiertem Aluminium gebildete Zwischenschicht 2 eine Dicke $D_2$ im Bereich von 5 nm bis 200 nm, vorzugsweise im Bereich von 10 bis 100 nm, aufweist. Wie bereits ausgeführt, wird so - wie in Fig. 2 dargestellt - vorteilhafterweise erfindungsgemäß im Rahmen des sogenannten Wire-bondings einerseits ein Verschweißen eines Drahtes D, insbesondere das Ultraschallschweißen eines Golddrahtes, auf der Vorder- bzw. Oberseite A des erfindungsgemäßen Verbundmaterials V möglich, so dass eine elektrische Verbindung (Schweißpunkt SP) zwischen der Oberfläche A des Verbundmaterials V und einem auf dem Verbundmaterial V durch Oberflächenmontage aufgebrachten elektronischen Bauteil SMD problemlos möglich ist.

Hierbei ist es bevorzugt, dass die Oberfläche der Zwischenschicht 2 einen arithmetischen Mittenrauwert $R_a$ im Bereich von weniger als 0,05 $\mu$m, insbesondere von weniger als 0,01 $\mu$m, besonders bevorzugt von weniger als 0,005 $\mu$m, aufweist. Dies dient bei Vorliegen des vorstehend genannten hohen Licht-Gesamtreflexionsgrades zur Einstellung eines nach DIN 5036 bestimmten, minimalen, diffusen Licht-Reflexionsgrades. Ist ein höherer diffuser Licht-Reflexionsgrad gefordert, kann die Rauheit entsprechend erhöht werden.

Auf der dem reflexionsverstärkenden optisch wirksamen Mehrschichtsystem 3 gegenüberliegenden Seite B des Trägers 1 befindet sich optional eine weitere aus Aluminiumoxid bestehende Schicht 8, die beispielsweise beim Eloxieren der Oberseite A herstellungsbedingt gleichzeitig entstehen kann. Ihre Ausbildung kann allerdings bedarfsweise durch eine Abdeckung der Seite B vermieden werden. Auch sind Verfahren bekannt, um derartige Schichten gegebenenfalls zu entfernen. Falls die weitere aus Aluminiumoxid bestehende Schicht 8 präsent ist, sollte ihre Dicke D8 im gleichen Bereich wie die Dicke $D_2$ der Zwischenschicht 2 liegen, also im Bereich von 5 nm bis 200 nm, vorzugsweise im Bereich von 10 bis 100 nm.

Ein weiteres erfindungswesentliches Merkmal besteht darin, dass auf der dem reflexionsverstärkenden, optisch wirksamen Mehrschichtsystem 3 gegenüberliegenden Seite B des Trägers 1 oberflächlich eine Schicht 9 eines Metalls oder einer Metalllegierung aufgebracht ist, welche(s) bei 25 °C einen spezifischen elektrischen Widerstand von maximal 1,2 * $10^{-1}$ $\Omega$ mm$^2$ / m aufweist, wobei die Dicke $D_9$ der oberflächlich aufgebrachten Schicht 9 im Bereich von 10 nm bis 5,0 $\mu$m liegt.

Insbesondere kann es sich um eine Kupferschicht handeln, die mit einer Dicke Dg im Bereich von 0,1 $\mu$m bis 5,0 $\mu$m, vorzugsweise im Bereich von 0,2 $\mu$m bis 3,0 $\mu$m, besonders bevorzugt im Bereich von 0,5 $\mu$m bis 1,5 $\mu$m aufgebracht ist.

Eine andere bevorzugte Ausführungsform der Erfindung sieht vor, dass die oberflächlich aufgebrachte Schicht 9 eine Silberschicht mit einer Dicke $D_9$ im Bereich von 10 nm bis 500 nm ist, insbesondere mit einer Dicke Dg im Bereich von 50 nm bis 250 nm.

Der spezifische elektrische Widerstand der oberflächlich aufgebrachten Schicht 9 eines Metalls oder einer Metalllegierung kann bei 25 °C bevorzugt einen Maximalwert von 2,7 * $10^{-2}$ $\Omega$ mm$^2$ / m, besonders bevorzugt einen Maximalwert von 1,8 * $10^{-2}$ $\Omega$ mm$^2$ / m, aufweisen.

Hinsichtlich der Werte des spezifischen elektrischen Widerstandes, der dabei für verschiedene Materialien zugrunde zu legen ist, wird auf die nachfolgende Tabelle 1 verwiesen, die auf der Grundlage von in der Literatur an verschiedenen Stellen genannten Werten zusammengestellt ist.

Tabelle 1: Werte des spezifischen elektrischen Widerstandes $\rho$ bei 25 °C

| MATERIAL | $\rho$ in $10^{-2}$ $\Omega$ mm$^2$ / m |
|---|---|
| $\rho \leq$ **1,8 * 10$^{-2}$** $\Omega$ **mm$^2$ / m** erfindungsgemäß besonders bevorzugt | |
| Ag | 1,59 |
| Cu | 1,69 - 1,72 |
| $\rho \leq$ **2,7 * 10$^{-2}$** $\Omega$ **mm$^2$ / m** erfindungsgemäß bevorzugt | |
| Al | 2,65 |
| Au | 2,21 |
| $\rho \leq$ **1,2 * 10$^{-1}$** $\Omega$ **mm$^2$ /m** erfindungsgemäß | |
| W | 5,3 |
| Ni | 6,9 - 7,1 |
| Pt | 10,5 |
| Pd | 10,7 |
| Sn | 10,9 |

Ein Überblick über spezifischen elektrischen Widerstand $\rho$ von zehn verschiedenen binären Legierungen (Al/Cu, Al/Mg, Cu/Au, Cu/Ni, Cu/Pd, Cu/Zn, Au/Pd, Au/Ag, Fe/Ni, Ag/Pd) mit jeweils verschiedener Zusammensetzung ist beispielsweise dem wissenschaftlichen Artikel "Electrical resistivity of ten selected binary alloys systems", Autor: Ho, C. Y. et al., in J. Phys. Chem. Ref. Data, Vol. 12 No. 2, 1983, S. 183 bis 322 zu entnehmen. Bei Feststellung einer bestimmten chemischen Zusammensetzung in der erfindungsgemäß vorgesehenen Schicht 9 kann auf diese Werte Bezug genommen werden.

Es ist aber auch eine direkte Messung nach ASTM F390-11 "Standard Test Method for Sheet Resistance of Thin Metallic Films With a Collinear Four-Probe-Array" möglich. Diese Norm enthält auch Angaben darüber, wie ein in der Einheit $\Omega$ bzw. "$\Omega$ square" ermittelter Flächenwiderstand ("Sheet Resistance") unter Berücksichtigung der Schichtgeometrie, also von deren Länge, Breite und Dicke, in einen spezifischen elektrischen Widerstand umgerechnet werden kann.

Zwischen dem aus Aluminium bestehenden Träger 1 bzw. der weiteren optional vorhandenen aus Aluminiumoxid bestehenden Schicht 8 und der Kupferschicht 9 kann in bevorzugter Ausbildung eine Haftvermittlerschicht 10 vorgesehen sein, die z. B. aus einem Übergangsmetall, insbesondere aus Titan, Chrom oder Nickel, besteht und deren Dicke $D_{10}$ bevorzugt im Bereich von 5 nm bis 25 nm, besonders bevorzugt im Bereich 10 nm bis 20 nm, liegen kann.

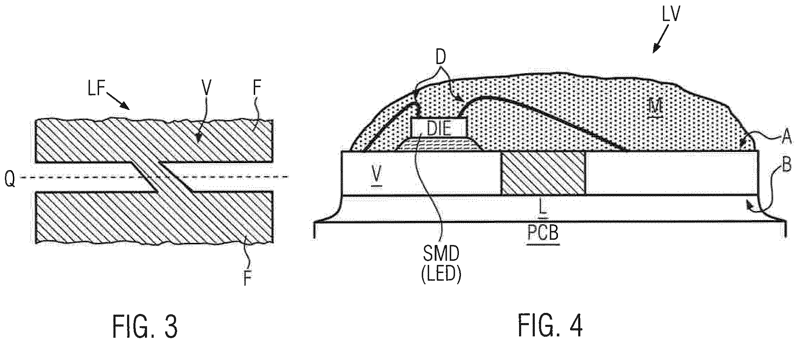

Wie ebenfalls bereits erwähnt, führt dies vorteilhafterweise dazu, dass der elektrische Übergangs-Widerstand auf der Rück- bzw. Unterseite B des erfindungsgemäßen Verbundmaterials V vernachlässigbar klein ist. So kann diese Seite B auf eine gedruckte Leiterplatte PCB gelötet oder mittels eines ähnlichen, stoffschlüssig wirkenden Verbindungsverfahrens aufgebracht werden. Die stoffschlüssig wirkende Verbindungsschicht ist in Fig. 1 und Fig. 4 jeweils mit dem Bezugszeichen L gekennzeichnet. Zum Verlöten können mit Vorteil beispielsweise zinnhaltige Standard-Elektrolote, wie z. B. Sn96.5Ag3Cu0.5, eingesetzt werden.

Trotz einer relativ dünnen Oberflächenschicht 9 des Metalls oder der Metalllegierung, insbesondere einer Kupferschicht, hat es sich gezeigt, dass es zwischen dem erfindungsgemäßen Verbundmaterial V und dem Lot nicht zu einer Ausbildung von relativ zur Schichtdicke $D_9$ dicken und spröden intermetallischen Phasen kommt, die durch thermische Spannungen zu einem mechanischen - und in der Folge auch zu einem elektrischen Versagen der Lötstelle - führen könnten. So führte eine Wärmelagerung von bis zu 1000 h nur zur Ausbildung einer wenige 100 nm dicken intermetallischen Phase. Es zeigte sich auch, dass die Lötverbindung der Verbindungsschicht L vorteilhafterweise typische Tests bestand, indem sich eine Abzugs- bzw. Scherkraft zwischen den verbundenen Bauteilen LF, COB nur um weniger als einen Faktor 2 nach einer Temperaturlagerung, z. B. bei 120 °C und 1000 h, reduzierte.

Auf der oberflächlich aufgebrachten Schicht 9 eines Metalls oder einer Metalllegierung, insbesondere auf der Kupferschicht, kann sich optional eine nicht dargestellte Passivierungsschicht befinden. Diese kann bevorzugt aus Ag, Ni, Pd und/oder Au (Ag/Ni/Pd/Au) bestehen und eine typische Dicke im Bereich von 10 nm bis 500 nm, bevorzugt im Bereich von 50 nm bis 250 nm, aufweisen. Eine derartige Schicht unterstützt aufgrund einer besseren Benetzbarkeit der Edelmetalloberfläche durch das Lot außerdem die Lötbarkeit des fertigen SMD-Bauteils auf das PCB.

Eine erfindungsgemäße lichtemittierende Vorrichtung LV - siehe dazu Fig. 2 und Fig. 4 - umfasst das erfindungsgemäße reflektierende Verbundmaterial V, welches eine Rahmen-Tragstruktur LF ("lead frame") für das elektronisches Bauelement SMD, wie eine als Nackt-Chip DIE ausgebildete, lichtemittierende Diode, bilden kann. Eine derartige Rahmen-Tragstruktur LF ist in Fig. 3 dargestellt. Sie besitzt in der dargestellten Form in der Draufsicht die Form eines H, wobei dessen Querbalken Q zwischen den als Fingern F bezeichneten Bahnen nicht rechtwinklig, sondern - wie dargestellt - häufig schräg verläuft. Eine derartige Rahmen-Tragstruktur LF kann in technologisch vorteilhafter Weise z. B. als Stanzteil oder durch Laserschneiden hergestellt werden. Bedarfsweise ist auch eine zusätzliche Ausbildung als Biegeteil möglich, da das Verbundmaterial V ohne Qualitätsverlust problemlos gebogen werden kann.

Hierbei kann eine Vielzahl von Rahmen-Tragstrukturen LF zunächst in einer als bandförmige Platine ausgebildeten Rahmen-Vorrichtung vereinigt sein, in der die Rahmen-Tragstrukturen LF über Stege feldförmig, d. h. als Zeilen- und Spaltenelemente, eingebunden sind. Aus der Rahmen-Vorrichtung können die Rahmen-Tragstrukturen LF einfach entfernt, beispielsweise herausgebrochen oder gestanzt, werden, so dass eine insbesondere automatisierte Massenproduktion von erfindungsgemäßen lichtemittierenden Vorrichtungen LV vorteilhafterweise leicht möglich ist. Die Rahmen-Tragstrukturen LF können dabei oberseitig bereits mit elektronischen Chips SMD bestückt werden.

In der erfindungsgemäßen lichtemittierenden Vorrichtung LV liegt das elektronische Bauelement SMD/DIE oberseitig, also auf der Seite A auf der Rahmen-Tragstruktur LF, auf und ist mittels mindestens eines separaten Drahtes D elektrisch mit der Rahmen-Tragstruktur LF kontaktiert. Neben dem LED-Die (Bezugszeichen: DIE) ist in Fig. 2 zusätzlich unten rechts eine Zener-Diode Z als weiteres oberflächenmontiertes elektronisches Bauteil SMD dargestellt. Der Verbund aus dem elektronischen Bauelement SMD bzw. - im dargestellten Fall den beiden dargestellten elektronischen Bauelementen SMD (DIE und Z) - und der Rahmen-Tragstruktur LF ist unterseitig (Seite B) mit einer gedruckten Leiterplatte PCB elektrisch leitend stoffschlüssig verbunden.

Auf dem Träger 1 können sich - abweichend von dem dargestellten Ausführungsbeispiel - auch andere reflexionsverstärkende Systeme 3 mit weiteren Schichten befinden. Diesbezüglich ist insbesondere dasjenige der DE 10 2015 114 095 A1 mit der reflexionsverstärkenden Silberschicht zu nennen, sofern es erfindungsgemäß ausgestaltet wird. Das in der WO 2017/032809 A1 beschriebene System sieht dagegen in der Zwischenschicht 2 zwingend die Präsenz eines organischen schichtbildenden Lackes mit bis zu 5 $\mu$m Dicke vor, was erfindungsgemäß vermieden werden sollte. Die Formulierung "Zwischenschicht 2 aus Aluminiumoxid" ist anmeldungsgemäß bevorzugt im Sinne von "ausschließlich bestehend aus" als abschließend zu betrachten, jedoch ist anmeldungsgemäß die Existenz von Teilschichten in der Zwischenschicht 2 gegebenenfalls nicht völlig auszuschließen. Unter diesem Gesichtspunkt sollte dann jedoch in jedem Fall die Dicke $D_2$ der gesamten Zwischenschicht 2 im Bereich von 5 nm bis 200 nm liegen. Wenngleich das optische Mehrschichtsystem 3 nicht nur die vorstehend beschriebenen Schichten 4, 5, 6 aufweisen kann, so darf erfindungsgemäß jedoch nicht vorgesehen sein, dass darauf als Deckschicht 7 eine organische oder siliciumorganische Lackschicht, z. B. auf der Basis einer Sol-Gel-Schicht, wie sie ebenfalls im Stand der Technik beschrieben ist, aufgebracht wird.

Der Fachmann kann im Rahmen der Ansprüche weitere zweckmäßige Ausgestaltungsformen der Erfindung vorsehen, ohne dass der Rahmen der Erfindung verlassen wird. So ist beispielsweise in Fig. 4 die Oberfläche der erfindungsgemäßen lichtemittierende Vorrichtung LV mit einer transparenten Masse M, z. B. mit einem Epoxidharz, vergossen. Alternativ oder zusätzlich könnten auch optische Linsensysteme über dem als LED-Chip DIE ausgebildeten elektronischen Bauteil SMD vorgesehen sein.

Insofern vorstehend von einer Silberschicht, insbesondere als Reflexionsschicht 6, die Rede ist, so schließt dies ein, dass eine solche Schicht Legierungselemente im Bereich von 0,001 Masseprozent bis 5,0 Masseprozent, insbesondere im Bereich von 0,5 Masseprozent bis 3,0 Masseprozent, enthalten kann. Bei den Legierungselementen kann es sich beispielsweise um ein Seltenerdelement, wie Neodym, handeln. Derartige Elemente können z. B. an die Korngrenzen des Silbers migrieren und/oder sich an der Oberfläche der Silberschicht anreichern, so dass sie dort eher als das edlere Silber oxidieren und auf den Silberkörnern eine mikroskopisch dünne Schutzschicht bilden. Die Wirksamkeit dieser Legierungselemente kann durch eine zusätzliche Zulegierung von Palladium, Platin, Gold und/oder Kupfer noch gesteigert werden. Auch wird dadurch eine Diffusionshemmung bewirkt, sowie einer Koaleszenz von Silberkristalliten, insbesondere bei höheren Temperaturen, wie sie im Betriebszustand auftreten können, entgegengewirkt. Dadurch kommt es vorteilhafterweise zu einer Entschleunigung der Alterung der Reflexionsschicht, d. h. einer Verzögerung des Abfalls der Reflektivität über die Zeit und/oder die Temperatur.

Palladium kann dem Silber auch als Hauptlegierungselement, vorzugsweise in einem Masseanteil im Bereich von 0,5 Masseprozent bis 3,0 Masseprozent der Legierung, zulegiert werden, wobei zusätzlich - in kleinerem oder höchstens dem gleichen Anteil - eines der Elemente Aluminium, Gold, Platin, Kupfer, Tantal, Chrom, Titan, Nickel, Kobalt oder Silizium als dritte Legierungskomponente präsent sein kann.

Silberschichten können auch, jedoch in vergleichsweise höheren Anteilen - insbesondere mit bis zu 70 Masseprozent, vorzugsweise im Bereich von 5 Masseprozent bis 30 Masseprozent, mit Molybdän legiert werden. Dies bewirkt ebenfalls eine Diffusionshemmung und außerdem eine verbesserte Haftfähigkeit des Silbers.

Auch Indium, Titan und/oder Zinn können als Legierungselemente für das Silber vorgesehen sein. Diesbezüglich erscheint beispielsweise eine Legierung als geeignet, die vorzugsweise Indium und/oder Zinn und/oder auch Antimon und/oder Wismut im Bereich von 0,5 Masseprozent bis 3,0 Masseprozent enthält, wobei der Rest aus Silber besteht.

Ein geeignetes Target, um in einem Sputterprozess Silber-Legierungsschichten zu erzeugen, ist auch in der EP 3 196 334 A1 beschrieben.

Die Erfindung ist nicht auf die in den unabhängigen Ansprüchen definierten Merkmalskombinationen beschränkt, sondern kann auch durch jede beliebige andere Kombination von bestimmten Merkmalen aller insgesamt offenbarten Einzelmerkmale definiert sein.

**Bezugszeichenliste**

| | |
|---|---|
| 1 | Träger von V |
| 2 | Zwischenschicht von V auf 1 (Seite A) |
| 3 | optisch wirksames Mehrschichtsystem von V auf 2 (Seite A) |
| 4, 5 | obere Schichten von 3 (Seite A) |
| 6 | unterste Schicht von 3, Reflexionsschicht (Seite A) |
| 7 | Deckschicht von V über 3 (Seite A) |
| 8 | $Al_2O_3$-Schicht von V auf 1 (Seite B) |
| 9 | Schicht eines Metalls oder einer Metalllegierung (Seite B) |

| | |
|---|---|
| A | Oberseite von 1 |
| B | Unterseite von 1 |
| D | Draht |
| $D_1$ | Dicke von 1 |
| $D_2$ | Dicke von 2 |
| $D_3$ | Dicke von 3 |
| $D_4$ | Dicke von 4 |
| $D_5$ | Dicke von 5 |
| $D_6$ | Dicke von 6 |
| $D_7$ | Dicke von 7 |
| $D_8$ | Dicke von 8 |
| $D_9$ | Dicke von 9 |
| DG | Gesamtdicke von V |
| DIE | lichtemittierende Diode, Nacktchip-Ausführungsform von SMD (Fig. 2, 4) |
| F | H-Finger von LF (Fig. 2, 3) |
| L | Verbindungsschicht zwischen V und PCB |
| LF | Rahmen-Tragstruktur (lead frame) |
| LV | lichtemittierende Vorrichtung mit V |
| M | transparente Masse von LV (Fig. 4) |
| PCB | printed circuit board |
| Q | H-Querbalken von LF (Fig. 3) |
| SMD | elektronisches Bauelement (surface mounted device) |
| SP | Schweißpunkt (Fig. 2) |
| V | Verbundmaterial |
| Z | Zenerdiode, Ausführungsform von SMD (Fig. 2) |

**Patentansprüche**

1. Reflektierendes Verbundmaterial (V) mit einer Ausbildung als Coil mit einer Breite bis zu 1600 mm, mit einem aus Aluminium bestehenden Träger (1), der eine Dicke ($D_1$) im Bereich von 0,1 bis 1,5 mm aufweist, mit einer auf einer Seite (A) auf dem Träger (1) befindlichen Zwischenschicht (2) aus Aluminiumoxid und mit einem auf der Zwischenschicht (2) aufgebrachten, reflexionsverstärkenden optisch wirksamen Mehrschichtsystem (3), wobei die aus Aluminiumoxid bestehende Zwischenschicht (2) eine Dicke ($D_2$) im Bereich von 5 nm bis 200 nm aufweist und auf der dem reflexionsverstärkenden optisch wirksamen Mehrschichtsystem (3) gegenüberliegenden Seite (B) des Trägers (1) oberflächlich eine Schicht (9) eines Metalls oder einer Metalllegierung aufgebracht ist, welche(s) bei 25 °C einen spezifischen elektrischen Widerstand von maximal $1{,}2 * 10^{-1}\ \Omega\ mm^2 / m$ aufweist, wobei die Dicke ($D_9$) der oberflächlich aufgebrachten Schicht (9) im Bereich von 10 nm bis 5,0 $\mu$m liegt.

**2.** Verbundmaterial (V) nach Anspruch 1,
**dadurch gekennzeichnet, dass** die auf der dem reflexionsverstärkenden optisch wirksamen Mehrschichtsystem (3) gegenüberliegenden Seite (B) des Trägers (1) oberflächlich aufgebrachte Schicht (9) eines Metalls oder einer Metalllegierung bei 25 °C einen spezifischen elektrischen Widerstand von maximal $2,7 * 10^{-2}\ \Omega\ mm^2 / m$, bevorzugt von maximal $1,8 * 10^{-2}\ \Omega\ mm^2 / m$, aufweist.

**3.** Verbundmaterial (V) nach Anspruch 1 oder 2,
**dadurch gekennzeichnet, dass** die aus Aluminiumoxid bestehende Zwischenschicht (2) eine Dicke ($D_2$) im Bereich von 10 bis 100 nm aufweist.

**4.** Verbundmaterial (V) nach einem der Ansprüche 1 bis 3,
**dadurch gekennzeichnet, dass** zwischen dem aus Aluminium bestehenden Träger (1) und der oberflächlich aufgebrachten Schicht (9) eines Metalls oder einer Metalllegierung (9) eine Haftvermittlerschicht (10) aus einem Übergangsmetall, insbesondere aus Titan, Chrom oder Nickel, angeordnet ist.

**5.** Verbundmaterial (V) nach einem der Ansprüche 1 bis 4,
**dadurch gekennzeichnet, dass** die oberflächlich aufgebrachte Schicht (9) eines Metalls oder einer Metalllegierung eine Kupferschicht ist, insbesondere mit einer Dicke ($D_9$) im Bereich von $0,1\ \mu m$ bis $5,0\ \mu m$, vorzugsweise im Bereich von $0,2\ \mu m$ bis $3,0\ \mu m$, besonders bevorzugt im Bereich von $0,5\ \mu m$ bis $1,5\ \mu m$.

**6.** Verbundmaterial (V) nach einem der Ansprüche 1 bis 4,
**dadurch gekennzeichnet, dass** die oberflächlich aufgebrachte Schicht (9) eines Metalls oder einer Metalllegierung eine Silberschicht ist, insbesondere mit einer Dicke ($D_9$) im Bereich von 10 nm bis 500 nm, bevorzugt im Bereich von 50 nm bis 250 nm.

**7.** Verbundmaterial (V) nach einem der Ansprüche 1 bis 6,
**dadurch gekennzeichnet, dass** auf der oberflächlich aufgebrachten Schicht (9) eines Metalls oder einer Metalllegierung eine Passivierungsschicht abgeschieden ist, die bevorzugt aus Ag, Ni, Pd und/oder Au besteht und eine Dicke im Bereich von 10 nm bis 500 nm, bevorzugt im Bereich von 50 nm bis 250 nm aufweist.

**8.** Verbundmaterial (V) nach einem der Ansprüche 1 bis 7,
**dadurch gekennzeichnet, dass** eine Silberschicht als oberflächlich aufgebrachte Schicht (9) eines Metalls oder einer Metalllegierung und/oder als eine darauf befindliche Passivierungsschicht und/oder als eine Reflexionsschicht (6) des reflexionsverstärkenden optisch wirksamen Mehrschichtsystems (3) legiert ist und als Legierungselement(e) ein oder mehrere Seltenerdelemente und/oder Palladium, Platin, Gold, Kupfer, Indium, Titan, Zinn und/oder Molybdän enthält.

**9.** Verbundmaterial (V) nach einem der Ansprüche 1 bis 8,
**dadurch gekennzeichnet, dass** eine oder mehrere der über der Zwischenschicht (2) angeordneten Schichten (4, 5, 6, 7), insbesondere des optischen Mehrschichtsystems (3), sowie die oberflächlich aufgebrachte Schicht (9) eines Metalls oder einer Metalllegierung und/oder die Passivierungsschicht Sputterschichten, insbesondere durch Reaktivsputtern erzeugte Schichten, CVD- oder PECVD-Schichten oder durch Verdampfen, insbesondere durch Elektronenbombardement oder aus thermischen Quellen, erzeugte Schichten sind.

**10.** Verbundmaterial (V) nach einem der Ansprüche 1 bis 9,
**dadurch gekennzeichnet, dass** das Aluminium des Trägers (1) eine höhere Reinheit als 99,0 % aufweist.

**11.** Verbundmaterial (V) nach einem der Ansprüche 1 bis 10,
**dadurch gekennzeichnet, dass** der Träger (1) eine Dicke ($D_1$) von 0,2 bis 0,8 mm, aufweist.

**12.** Verbundmaterial (V) nach einem der Ansprüche 1 bis 11,
**dadurch gekennzeichnet, dass** ein nach DIN 5036, Teil 3 (Ausgabe 11/79) bestimmter Licht-Gesamtreflexionsgrad auf der Seite (A) des optischen Mehrschichtsystems (3) größer ist als 97 % und vorzugsweise mindestens 98 % beträgt.

**13.** Verbundmaterial (V) nach einem der Ansprüche 1 bis 12,
**gekennzeichnet durch** eine Ausbildung als Coil mit einer Breite von 1250 mm.

**14.** Lichtemittierende Vorrichtung (LV), umfassend ein Verbundmaterial (V) nach einem der Ansprüche 1 bis 13, welches eine Rahmen-Tragstruktur (LF) für ein elektronisches Bauelement (SMD) bildet, wobei das elektronische Bauelement (SMD) auf der Oberseite (A) auf der Rahmen-Tragstruktur (LF) aufliegt und befestigt ist sowie mittels eines separaten Drahtes (D) elektrisch mit der Rahmen-Tragstruktur (LF) kontaktiert ist, und wobei der Verbund aus dem elektronischen Bauelement (SMD) und der Rahmen-Tragstruktur (LF) auf der Unterseite (B) mit einer Leiterplatte (PCB) elektrisch leitend stoffschlüssig verbunden ist.

**15.** Lichtemittierende Vorrichtung (LV) nach Anspruch 14,
**dadurch gekennzeichnet, dass** die Rahmen-Tragstruktur (LF) mit der Leiterplatte (PCB) über eine zinnhaltige Lotschicht (L) verbunden ist.

**16.** Lichtemittierende Vorrichtung (LV) nach Anspruch 15 mit einem Verbundmaterial (V) nach den Ansprüchen 4 und 5,
**dadurch gekennzeichnet, dass** zwischen dem Verbundmaterial (V) und der Lotschicht (L) keine intermetallischen Phasen vorliegen, die durch thermische Spannungen zu einem mechanischen und elektrischen Versagen der Lötstelle führen.

**17.** Lichtemittierende Vorrichtung (LV) nach Anspruch 14 oder 15,
**dadurch gekennzeichnet, dass** das elektronische Bauelement (SMD) eine als Chip (DIE) ausgebildete lichtemittierende Diode (LED) ist.

**18.** Verwendung eines reflektierenden Verbundmaterials (V) nach einem der Ansprüche 1 bis 13 zur Herstellung einer lichtemittierenden Vorrichtung (LV) nach einem der Ansprüche 14 bis 17, wobei im Gegensatz zu einer Durchsteckmontage ein oberflächenmontierbares elektronisches Bauelement (SMD) auf die Oberseite (A) des durch Stanzen oder durch Laserschneiden, gegebenenfalls mit einer zusätzlichen Ausbildung als Biegeteil, als Rahmen-Tragstruktur (LF) ausgebildeten Verbundmaterials (V) aufgelegt und dort befestigt sowie mittels eines separaten Drahtes (D) elektrisch mit der Rahmen-Tragstruktur (LF) kontaktiert wird, wobei der Verbund aus dem elektronischen Bauelement (SMD) und der Rahmen-Tragstruktur (LF) auf der Unterseite (B) mit einer Leiterplatte (PCB) elektrisch leitend stoffschlüssig verbunden wird.

**19.** Verwendung nach Anspruch 18,
**dadurch gekennzeichnet, dass** der separate Draht (D) ein Golddraht ist, mittels dessen durch Ultraschallschweißen über einen Schweißpunkt (SP) eine elektrische Verbindung zwischen der Oberseite (A) des Verbundmaterials (V) und dem auf dem Verbundmaterial (V) durch Oberflächenmontage aufgebrachten elektronischen Bauteil (SMD) gebildet wird.

**20.** Verwendung nach Anspruch 18 oder 19,
**dadurch gekennzeichnet, dass** die Rahmen-Tragstruktur (LF) in der Draufsicht die Form eines H besitzt, dessen Querbalken (Q) zwischen als aus Fingern (F) ausgebildeten Bahnen schräg verläuft.

**21.** Verwendung nach einem der Ansprüche 18 bis 20,
**dadurch gekennzeichnet, dass** eine Vielzahl von Rahmen-Tragstrukturen (LF) zunächst in einer als bandförmige Platine ausgebildeten Rahmen-Vorrichtung vereinigt sind, in der die Rahmen-Tragstrukturen (LF) über Stege feldförmig, d. h. als Zeilen- und Spaltenelemente, eingebunden sind, wobei für eine automatisierte Massenproduktion von lichtemittierenden Vorrichtungen (LV) die Rahmen-Tragstrukturen (LF) aus der Rahmen-Vorrichtung entfernt, beispielsweise herausgebrochen oder gestanzt, werden.

**Claims**

**1.** Reflective composite material (V) with a configuration as coil with width up to 1600 mm, with a carrier (1) consisting of aluminium and having thickness ($D_1$) in the range from 0.1 to 1.5 mm, with, located on one side (A) of the carrier (1), an interlayer (2) made of aluminium oxide, and with, applied on the interlayer (2), an optically active reflection-boosting multilayer system (3), where the interlayer (2) consisting of aluminium oxide has thickness ($D_2$) in the range from 5 nm to 200 nm, and a layer (9) of a metal or of a metal alloy has been applied superficially on that side (B) of the carrier (1) that is opposite to the optically active reflection-boosting multilayer system (3), where the electrical resistivity at 25°C of the said metal or metal alloy is at most $1.2 * 10^{-1}$ $\Omega$ mm$^2$/m, where the thickness (Dg) of the layer (9) applied superficially is in the range 10 nm to 5.0 $\mu$m.

2. Composite material (V) according to Claim 1, **characterized in that** the electrical resistivity at 25°C of the layer (9) of a metal or metal alloy superficially applied on that side (B) of the carrier (1) that is opposite to the optically active reflection-boosting multilayer system (3) is at most $2.7 * 10^{-2} \, \Omega \, mm^2/m$, preferably at most $1.8 * 10^{-2} \, \Omega \, mm^2/m$.

3. Composite material (V) according to Claim 1 or 2, **characterized in that** the thickness ($D_2$) of the interlayer (2) consisting of aluminium oxide is in the range 10 to 100 nm.

4. Composite material (V) according to any of Claims 1 to 3,
   **characterized in that** an adhesion-promoter layer (10) made of a transition metal, in particular of titanium, chromium or nickel, is arranged between the carrier (1) consisting of aluminium and the layer (9) of a metal or metal alloy superficially applied.

5. Composite material (V) according to any of Claims 1 to 4,
   **characterized in that** the layer (9) of a metal or metal alloy superficially applied is a copper layer, in particular with thickness (Dg) in the range of 0.1 $\mu$m to 5.0 $\mu$m, preferably in the range from 0.2 $\mu$m to 3.0 $\mu$m, particularly preferably in the range from 0.5 $\mu$m to 1.5 $\mu$m.

6. Composite material (V) according to any of Claims 1 to 4,
   **characterized in that** the layer (9) of a metal or metal alloy superficially applied is a silver layer, in particular with thickness (Dg) in the range of 10 nm to 500 nm, preferably in the range from 50 nm to 250 nm.

7. Composite material (V) according to any of Claims 1 to 6,
   **characterized in that** a passivating layer has been deposited on the layer (9) of a metal or metal alloy superficially applied, and preferably consists of Ag, Ni, Pd and/or Au, its thickness being in the range 10 nm to 500 nm, preferably in the range 50 nm to 250 nm.

8. Composite material (V) according to any of Claims 1 to 7,
   **characterized in that** a silver layer as layer (9) of a metal or metal alloy superficially applied and/or as a passivating layer located thereon and/or as a reflective layer (6) of the optically active reflection-boosting multilayer system (3) takes the form of an alloy and comprises, as alloy element (s), one or more rare earth elements and/or palladium, platinum, gold, copper, indium, titanium, tin and/or molybdenum.

9. Composite material (V) according to any of Claims 1 to 8,
   **characterized in that** one or more of the layers (4, 5, 6, 7) arranged above the interlayer (2), in particular of the optical multilayer system (3), and the layer (9) of a metal or metal alloy superficially applied, and/or the passivating layer, are sputter layers, in particular layers produced by reactive sputtering, CVD layers or PECVD layers, or layers produced by evaporation, in particular by electron bombardment or from thermal sources.

10. Composite material (V) according to any of Claims 1 to 9,
    **characterized in that** the purity of the aluminium of the carrier (1) is above 99.0%.

11. Composite material (V) according to any of Claims 1 to 10,
    **characterized in that** the thickness ($D_1$) of the carrier (1) is 0.2 to 0.8 mm.

12. Composite material (V) according to any of Claims 1 to 11,
    **characterized in that** a total light reflectance determined in accordance with DIN 5036, Part 3 (Issue of 11/79) on the side (A) of the optical multilayer system (3) is above 97% and preferably at least 98%.

13. Composite material (V) according to any of Claims 1 to 12,
    **characterized by** a configuration as coil with width 1250 mm.

14. Light-emitting device (LV) comprising a composite material (V) according to any of Claims 1 to 13, which forms a lead frame (LF) for an electronic component (SMD), where the electronic component (SMD) lies on and is secured to the upper side (A) on the lead frame (LF) and is electrically contacted to the lead frame (LF) by means of a separate wire (D), and where the composite made of the electronic component (SMD) and of the lead frame (LF) has been cohesively bonded on the underside (B) in electrically conductive manner to a printed circuit board (PCB).

15. Light-emitting device (LV) according to Claim 14, **characterized in that** the lead frame (LF) has been connected to the printed circuit board (PCB) by way of a tin-containing solder layer (L).

16. Light-emitting device (LV) according to Claim 15 with a composite material (V) according to Claims 4 and 5, **characterized in that**, between the composite material (V) and the solder layer (L), there are no intermetallic phases which lead to mechanical and electrical failure of the soldered joint due to thermal stresses.

17. Light-emitting device (LV) according to Claim 14 or 15, **characterized in that** the electronic component (SMD) is a light-emitting diode (LED) configured as chip (DIE).

18. Use of a reflective composite material (V) according to any of Claims 1 to 13 for producing a light-emitting device (LV) according to any of Claims 14 to 17, where, in contrast to a through-hole assembly technology, a surface-mountable electronic component (SMD) is placed onto the and secured on the upper side (A) of the composite material (V) configured as lead frame (LF) by die-cutting or by laser cutting, optionally with additional configuration as a bending part, and is electrically contacted to the lead frame (LF) by means of a separate wire (D), where the composite made of the electronic component (SMD) and of the lead frame (LF) is cohesively bonded on the underside (B) in electrically conductive manner to a printed circuit board (PCB).

19. Use according to Claim 18, **characterized in that** the separate wire (D) is a gold wire by means of which, through ultrasound welding via a weld point (SP), an electrical connection is formed between the upper side (A) of the composite material (V) and the electronic component (SMD) applied by surface mounting on the composite material (V).

20. Use according to Claim 18 or 19, **characterized in that** the lead frame (LF) has the shape of an H in plan view, where the crossbar (Q) thereof runs obliquely between tracks configured as from fingers (F).

21. Use according to any of Claims 18 to 20, **characterized in that** a large number of lead frames (LF) are first combined in a frame device in the form of a circuit board in strip form, in which the lead frames (LF) are incorporated in fields, i.e. in the form of line elements and column elements, by way of connectors, where for automated mass production of light-emitting devices (LV), the lead frames (LF) are removed from the frame device, for example broken away or die-cut.

**Revendications**

1. Matériau composite réfléchissant (V) présentant une conception en forme de bobine qui a une largeur pouvant atteindre 1600 mm et qui comprend un support (1) en aluminium qui a une épaisseur ($D_1$) dans la plage de 0,1 à 1,5 mm, une couche intermédiaire (2) en oxyde d'aluminium située sur un côté (A) du support (1) et un système multicouche (3) optiquement actif amplificateur de réflexion et appliqué sur la couche intermédiaire (2), la couche intermédiaire (2) en oxyde d'aluminium ayant une épaisseur ($D_2$) dans la plage de 5 nm à 200 nm et, une couche (9) en métal ou en alliage de métal, qui présente une résistance électrique spécifique de $1,2 * 10^{-1}$ $\Omega$ mm$^2$/m maximum à 25 °C, étant appliquée en surface sur le côté (B) du support (1) qui opposé au système multicouche optiquement actif amplificateur de réflexion (3), l'épaisseur (Dg) de la couche (9) appliquée en surface étant dans la plage de 10 nm à 5,0 $\mu$m.

2. Matériau composite (V) selon la revendication 1, **caractérisé en ce que** la couche (9) en métal ou en alliage de métal, appliquée en surface sur le côté (B) du support (1) qui est opposée au système multicouche (3) optiquement actif amplificateur de réflexion, présente à 25 °C une résistance électrique spécifique de $2,7 * 10^{-2}$ $\Omega$ mm$^2$/m maximum, de préférence $1,8 * 10^{-2}$ $\Omega$ mm$^2$/m maximum.

3. Matériau composite (V) selon la revendication 1 ou 2, **caractérisé en ce que** la couche intermédiaire (2) en oxyde d'aluminium a une épaisseur ($D_2$) dans la plage de 10 à 100 nm.

4. Matériau composite (V) selon l'une des revendications 1 à 3, **caractérisé en ce qu'**une couche de promotion d'adhérence (10) en métal de transition, en particulier en titane, en chrome ou en nickel, est disposée entre le support (1) en aluminium et la couche (9) en métal ou en alliage de métal (9) appliquée en surface.

5. Matériau composite (V) selon l'une des revendications 1 à 4,**caractérisé en ce que** la couche (9) en métal ou en alliage de métal appliquée en surface est une couche de cuivre, en particulier d'une épaisseur (Dg) dans la plage de 0,1 $\mu$m à 5,0 $\mu$m, de préférence dans la plage de 0,2 $\mu$m à 3,0 $\mu$m, de manière particulièrement préférée dans la plage de 0,5 $\mu$m à 1,5 $\mu$m.

6. Matériau composite (V) selon l'une des revendications 1 à 4, **caractérisé en ce que** la couche (9) en métal ou en alliage de métal appliquée en surface est une couche d'argent, en particulier d'une épaisseur (Dg) dans la plage de 10 nm à 500 nm, de préférence dans la plage de 50 nm à 250 nm.

7. Matériau composite (V) selon l'une des revendications 1 à 6, **caractérisé en ce qu'**une couche de passivation, qui est de préférence en Ag, Ni, Pd et/ou Au et qui a une épaisseur dans la plage de 10 nm à 500 nm, de préférence dans la plage de 50 nm à 250 nm, est déposée sur la couche (9) en métal ou en alliage de métal appliquée en surface.

8. Matériau composite (V) selon l'une des revendications 1 à 7, **caractérisé en ce qu'**une couche d'argent est alliée comme couche (9) en métal ou en alliage de métal appliquée en surface et/ou comme couche de passivation située sur celle-ci et/ ou comme couche réfléchissante (6) du système multicouche optiquement actif amplificateur de réflexion (3) et contient comme élément(s) d'alliage un ou plusieurs éléments de terres rares et/ou du palladium, du platine, de l'or, du cuivre, de l'indium, du titane, de l'étain et/ou du molybdène.

9. Matériau composite (V) selon l'une des revendications 1 à 8, **caractérisé en ce qu'**une ou plusieurs des couches (4, 5, 6, 7) disposées au-dessus de la couche intermédiaire (2), en particulier du système multicouche optique (3), et la couche (9) appliquée en surface en métal ou en alliage de métal et/ou la couche de passivation sont des couches de pulvérisation cathodique, notamment des couches générées par pulvérisation cathodique réactive, des couches CVD ou PECVD ou des couches générées par évaporation, notamment par bombardement électronique ou à partir de sources thermiques.

10. Matériau composite (V) selon l'une des revendications 1 à 9, **caractérisé en ce que** l'aluminium du support (1) a une pureté supérieure à 99,0 %.

11. Matériau composite (V) selon l'une des revendications 1 à 10, **caractérisé en ce que** le support (1) a une épaisseur (D$_1$) de 0,2 à 0,8 mm.

12. Matériau composite (V) selon l'une des revendications 1 à 11, **caractérisé en ce qu'**une réflectance lumineuse totale, déterminée selon DIN 5036, partie 3 (édition 11/79), sur le côté (A) du système multicouche optique (3) est supérieure à 97 % et de préférence d'au moins 98 %.

13. Matériau composite (V) selon l'une des revendications 1 à 12, **caractérisé par** une conception en forme de bobine d'une largeur de 1250 mm.

14. Dispositif électroluminescent (LV), comprenant un matériau composite (V) selon l'une des revendications 1 à 13, qui forme une structure de support de cadre (LF) destinée à un composant électronique (SMD), le composant électronique (SMD) étant en appui et fixé sur le côté supérieur (A) de la structure de support de cadre (LF) et étant électriquement en contact avec la structure de support de cadre (LF) au moyen d'un fil séparé (D), et la combinaison du composant électronique (SMD) et de la structure de support de cadre (LF) étant reliée électriquement sur le côté inférieure (B) à une carte de circuit imprimé (PCB) par une liaison de matière.

15. Dispositif électroluminescent (LV) selon la revendication 14, **caractérisé en ce que** la structure de support de cadre (LF) est reliée à la carte de circuit imprimé (PCB) par l'intermédiaire d'une couche de soudure (L) contenant de l'étain.

16. Dispositif électroluminescent (LV) selon la revendication 15 comprenant un matériau composite (V) selon les revendications 4 et 5, **caractérisé en ce qu'**aucune phase intermétallique, qui entraîne une défaillance mécanique et électrique du point de soudure en raison de contraintes thermiques, n'est présente entre le matériau composite (V) et la couche de soudure (L).

17. Dispositif électroluminescent (LV) selon la revendication 14 ou 15, **caractérisé en ce que** le composant électronique (SMD) est une diode électroluminescente (LED) conçue sous la forme d'une puce (DIE) .

18. Utilisation d'un matériau composite réfléchissant (V) selon l'une des revendications 1 à 13 pour réaliser un dispositif électroluminescent (LV) selon l'une des revendications 14 à 17, contrairement à un montage traversant un composant électronique (SMD) qui peut être monté en surface étant placé sur le côté supérieur (A) du matériau composite (V) conçu comme une structure de support de cadre (LF) par emboutissage ou par découpe au laser, éventuellement avec une conception supplémentaire sous la forme d'une partie pliée, et étant fixée audit côté supérieur et étant électriquement en contact avec la structure de support de cadre (LF) au moyen d'un fil séparé (D), la combinaison du composant électronique (SMD) et de la structure de support de cadre (LF) étant reliée électriquement à une carte de circuit imprimé (PCB) sur le côté inférieure (B) par une liaison de matière.

19. Utilisation selon la revendication 18, **caractérisé en ce que** le fil séparé (D) est un fil d'or permettant d'établir une liaison électrique entre le côté supérieur (A) du matériau composite (V) et le composant électronique (SMD), appliqué sur le matériau composite (V) par montage en surface, par soudage par ultrasons via un point de soudage (SP).

20. Utilisation selon la revendication 18 ou 19, **caractérisé en ce que** la structure de support de cadre (LF) a en vue de dessus la forme d'un H dont la barre transversale (Q) s'étend obliquement entre des pistes conçues à partir de doigts (F).

21. Utilisation selon l'une des revendications 18 à 20, **caractérisée en ce qu'**un grand nombre de structures de support de cadre (LF) sont initialement combinées e un dispositif de cadre qui est conçu comme une platine en forme de bande et dans lequel les structures de support de cadre (LF) sont intégrées via des nervures sous la forme d'une zone, c'est-à-dire sous la forme d'éléments de ligne et de colonne, les structures de support de cadre (LF) étant retirées du dispositif de cadre, par exemple par cassure ou matriçage, pour une production en série automatisée de dispositifs électroluminescents (LV) .

FIG. 1

FIG. 2

FIG. 3

FIG. 4

EP 3 428 696 B1

**IN DER BESCHREIBUNG AUFGEFÜHRTE DOKUMENTE**

**In der Beschreibung aufgeführte Patentdokumente**

- WO 0029784 A1
- DE 10340005 A1
- US 6407411 B1
- EP 2138761 A1
- DE 102015114095 A1
- WO 2017032809 A1
- DE 29812559 U1
- EP 3196334 A1

**In der Beschreibung aufgeführte Nicht-Patentliteratur**

- **HO, C. Y. et al.** Electrical resistivity of ten selected binary alloys systems. *J. Phys. Chem. Ref. Data,* 1983, vol. 12 (2), 183-322